# EUROPEAN PATENT SPECIFICATION

(11) **EP 4 383 957 B1**
(45) Date of publication and mention of the grant of the patent: **04.02.2026**
(21) Application number: 23211084.1
(22) Date of filing: 21.11.2023
(51) Int. Cl.: H05K 1/02, H05K 1/11

(54) **ELECTRICAL DEVICE**
ELEKTRISCHE VORRICHTUNG
DISPOSITIF ÉLECTRIQUE

(30) Priority: 08.12.2022 CN 202223284970 U
(43) Date of publication of application: 12.06.2024
(73) Proprietor: Huawei Digital Power Technologies Co., Ltd., Shenzhen, 518043 (CN)
(72) Inventor: YU, Pengpeng, Shenzhen, 518043 (CN)
(74) Representative: Epping - Hermann - Fischer

(56) References cited:
- US-A- 4 079 440
- US-A- 5 982 253
- US-A1- 2004 235 326
- "ELECTROSTATIC DISCHARGE PROTECTION FOR CARD-EDGE CONNECTORS", RESEARCH DISCLOSURE, KENNETH MASON PUBLICATIONS, HAMPSHIRE, UK, GB, no. 308, 1 December 1989 (1989-12-01), pages 941, XP000096112, ISSN: 0374-4353

## Description

### TECHNICAL FIELD

This application relates to the field of electrical connection technologies, and in particular, to an electrical device.

### BACKGROUND

A hot swap technology is also referred to as a hot plugging technology. According to the hot swap technology, during a connection of an electrical device to a piece of power sourcing equipment (for example, a power module, or a power supply board connected to a power grid) in a plugging manner, the electrical device can be connected to or removed from the power sourcing equipment without causing power interruption, so that the power sourcing equipment can run continuously when the electrical device is inserted into or removed from the power sourcing equipment, thereby facilitating online maintenance.

In a conventional technology, the electrical device may include an edge connector, where the edge connector has two connection terminals disposed at an interval, and the edge connector is configured to connect, in a plugging manner, to an output-end connector corresponding to the power sourcing equipment, so that the two connection terminals are separately and electrically in contact with two corresponding output terminals of the output-end connector, thereby enabling the electrical device to be electrically connected to the power sourcing equipment.

However, in the conventional technology, when hot swap is performed between the edge connector of the electrical device, such as a power module having high power and high power density, and the output-end connector of the power sourcing equipment having a high output voltage, phenomena such as sparking and ablation may easily occur, and electrical connections between the electrical device and the power sourcing equipment may be easily affected.

US 2004/235326 Al discloses a circuit card having a conductive pad configured to join a mating element having a charge build-up as a mating element moves along a mating direction, wherein the conductive pad comprises: first and second contact portions separate and distinct from one another, aligned in-line with one another on a common side of the circuit card and aligned along the mating direction such that the first contact portion is positioned to receive the mating element before the second contact portion receives the mating element; and a charge-controlling device connected to the first contact portion to establish an electrical path in which the charge build-up is discharged through the charge controlling device.

The document "Electrostatic discharge protection for card-edge connectors" from Kenneth Mason Publications describes that the card-edge connector trace is divided into two parts, the part that first makes contact when the card is inserted is connected to the semiconductor pin via a surface-mounted resistor, and the other part of the trace is connected directly to the semiconductor pin, bypassing the resistor. The document further describes that by the time the second part of the connector traces makes contact, the potentials of the semiconductor pins and the connecting device have been equalized.

US 4 079 440 A discloses a printed circuit board loaded with electronic circuits, wherein the board has at least two connector plugs for power supply, one being relatively long and the other relatively short. It describes that these connector plugs are connected to each other through an impedance element and that during insertion of the board into a power line, the longer connector plug contacts the power line earlier than the shorter one, while during withdrawal, the longer connector plug disconnects from the line later than the shorter one.

### SUMMARY

The invention is defined by the appended claims. An embodiment of this application provides an electrical device, where at least one power terminal of the electrical device is partitioned into two conductive sections that are spaced along an insertion direction of a substrate and are connected in series by using a resistor, and capacitors are disposed between power circuits that are electrically connected to two power terminals. When hot swap is performed between the electrical device and a piece of power sourcing equipment, current-limiting charging is first performed on the capacitors by using a conductive section located in the front of the insertion direction; and then a conductive section located at the rear of the insertion direction of the substrate is connected to implement power input. In this way, even if an output voltage of the power sourcing equipment is relatively high, phenomena such as sparking and ablation are not likely to occur at the two power terminals, and electrical connections between the electrical device and the power sourcing equipment are not easily affected.

An embodiment of this application provides an electrical device, including a substrate. Two power terminals are disposed at an interval along a first direction on the substrate, each power terminal is electrically connected to a power circuit, capacitors are disposed between the two power circuits, one end of the capacitor is electrically connected to one of the power circuits, and another end of the capacitor is electrically connected to the other power circuit. At least one of the power terminals includes a first conductive section, a resistor, and a second conductive section. In the same power terminal, the first conductive section, the resistor, and the second conductive section are connected in series, the first conductive section is electrically connected by using the resistor and the second conductive section to the power circuit, both the first conductive section and the second conductive section are located on a surface on a same side of the substrate, and in an insertion direction of the substrate, the first conductive section is disposed at an interval in front of the second conductive section, so that the first conductive section is disconnected from the second conductive section in the insertion direction of the substrate, where the first direction is perpendicular to the insertion direction of the substrate. One of the two power terminals is a first power terminal, the other is a second power terminal, and the first power terminal includes the first conductive section, the resistor, and the second conductive section; and in the first direction, a spacing between the first conductive section of the first power terminal and the second power terminal is greater than a spacing between the second conductive section of the first power terminal and the second power terminal.

According to the electrical device provided in this embodiment of this application, at least one of the power terminals is partitioned into the first conductive section and the second conductive section that are spaced along the insertion direction of the substrate and are connected in series by using the resistor, and the capacitors are disposed between the power circuits electrically connected to the two power terminals. When hot swap is performed between the electrical device having high power and a high power density and a piece of power sourcing equipment, the first conductive section of the at least one of the power terminals alone may first be electrically in contact with an output terminal corresponding to the power sourcing equipment, so that the two power terminals are connected to the power sourcing equipment. In this case, a first capacitor is charged by a current that has undergone current limiting of a first resistor. Because of the current limiting effect of the first resistor, a current at the first conductive section is relatively small, so that impulse currents are relatively small when the two power terminals are connected to the power sourcing equipment. The first capacitor is charged by using the first conductive section and the first resistor, to enable a voltage between two ends of the first capacitor to rise. Then a voltage between the two power terminals is enabled to rise. When the substrate continues to be inserted till the second conductive section is electrically in contact with a corresponding output terminal to implement power input, potential differences between the two power terminals and the two corresponding output terminals may be relatively small, or even equal potentials may be formed between the two power terminals and the two corresponding output terminals. In this case, currents flowing into the corresponding power terminals through the output terminals are relatively small or even may be zero, and at a moment when the second conductive section is electrically in contact with the corresponding output terminal, impulse currents at the two power terminals are also relatively small. In this way, a risk of phenomena such as sparking and ablation at the two power terminals can be reduced, thereby helping improve user experience. In addition, this helps improve stability of contact impedance between the power terminal and the corresponding output terminal, and helps improve stability of electrical connections between the electrical device and the power sourcing equipment. In addition, the relatively small impulse currents also help protect components on a power loop where the two power circuits are located.

In a possible implementation, in the same power terminal, a projection of the first conductive section along the insertion direction of the substrate overlaps at least partially with a projection of the second conductive section along the insertion direction of the substrate.

In a possible implementation, in the same power terminal, the projection of the first conductive section along the insertion direction of the substrate falls within the projection of the second conductive section along the insertion direction of the substrate.

In a possible implementation, the substrate includes a printed circuit board, and the two power terminals are disposed at the interval along the first direction on the printed circuit board; and both the first conductive section and the second conductive section are located on a surface on a same side of the printed circuit board, and the power circuit is located at least partially on the printed circuit board.

In a possible implementation, the resistor is disposed on the printed circuit board.

In a possible implementation, both the first conductive section and the second conductive section are strip-shaped conductive sheets extending along the insertion direction of the substrate.

In a possible implementation, in the first direction, a width of the first conductive section of the first power terminal is less than a width of the second conductive section of the first power terminal.

In a possible implementation, in the first direction, a width of a part that is of the second power terminal and that is opposite to the first conductive section of the first power terminal is less than a width of a part that is of the second power terminal and that is opposite to the second conductive section of the first power terminal.

In a possible implementation, in the same power terminal, a length of the first conductive section along the insertion direction of the substrate is less than a length of the second conductive section along the insertion direction of the substrate.

In a possible implementation, each of the two power terminals includes the first conductive section, the resistor, and the second conductive section; and in the first direction, the first conductive sections of the two power terminals are disposed as being opposite to each other in the front of the insertion direction of the substrate.

In a possible implementation, the power circuit electrically connected to one of the power terminals is a live-wire circuit, and the power circuit electrically connected to the other power terminal is a neutral-wire circuit; and a ground terminal is further disposed on the substrate, the ground terminal is disposed at intervals from the power terminals along the first direction, and the ground terminal is electrically connected to a grounding circuit.

### BRIEF DESCRIPTION OF DRAWINGS

The embodiments detailed along Figures 1-6 are not according to the claimed invention but useful for understanding the invention.
FIG. 1 is a schematic diagram of positions where power terminals of an electrical device are disposed according to an embodiment of this application;
FIG. 2 is a schematic diagram of electrical connections between power terminals of an electrical device and power circuits of the electrical device according to an embodiment of this application;
FIG. 3 is another schematic diagram of positions where power terminals of an electrical device are disposed according to an embodiment of this application;
FIG. 4 is another schematic diagram of electrical connections between power terminals of an electrical device and power circuits of the electrical device according to an embodiment of this application;
FIG. 5 is still another schematic diagram of positions where power terminals of an electrical device are disposed according to an embodiment of this application;
FIG. 6 is still another schematic diagram of electrical connections between power terminals of an electrical device and power circuits of the electrical device according to an embodiment of this application;
FIG. 7 is yet another schematic diagram of positions where power terminals of an electrical device are disposed according to an embodiment of this application;
FIG. 8 is still yet another schematic diagram of positions where power terminals of an electrical device are disposed according to an embodiment of this application;
FIG. 9 is a further schematic diagram of positions where power terminals of an electrical device are disposed according to an embodiment of this application; and
FIG. 10 is a still further schematic diagram of positions where power terminals of an electrical device are disposed according to an embodiment of this application.

### Reference numerals:

100: power terminal; 110: first conductive section; 120: first resistor; 130: second conductive section; 140: first power terminal; 150: second power terminal;
200: power circuit; 210: inductor; 220: first circuit; 230: second circuit;
310: first capacitor; 320: second capacitor; 330: second resistor; 340: third capacitor;
400: ground terminal;
500: grounding circuit;
600: substrate; 610: printed circuit board.

### DESCRIPTION OF EMBODIMENTS

Terms used in implementations of this application are merely used to explain specific embodiments of this application, but are not intended to limit this application. The following describes implementations of embodiments of this application in detail with reference to the accompanying drawings.

Embodiments of this application provide an electrical device, which may include but is not limited to a power supply unit (Power Supply Unit, PSU), a circuit breaker, a transformer, a power distribution box, and the like.

In embodiments of this application, description is provided by using an example in which the electrical device is a power module. The power module may be a power module with alternating-current input, or may be a power module with direct-current input. The power module may be a power module configured to output an alternating current, or may be a power module configured to output a direct current.

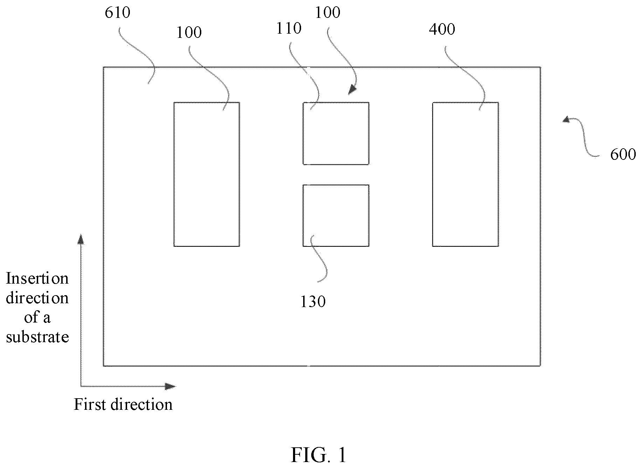

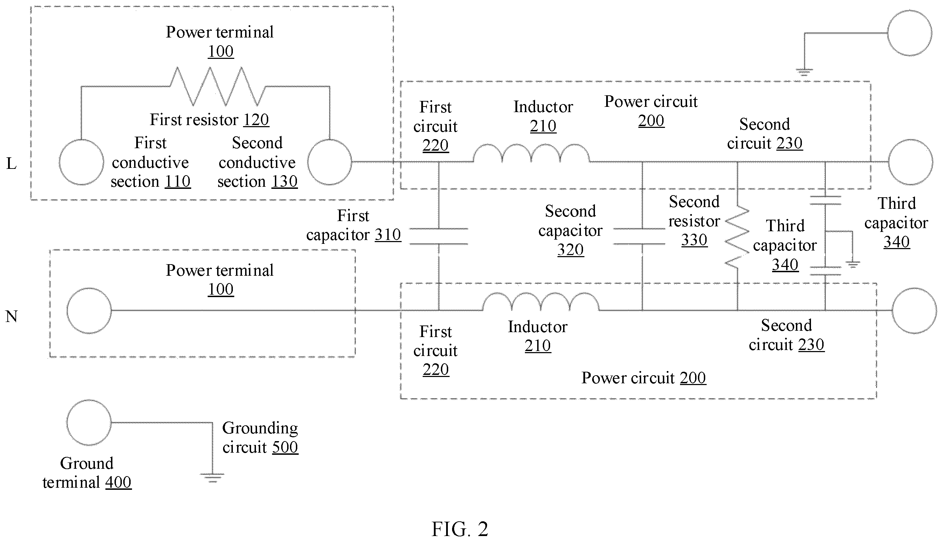

FIG. 1 is a schematic diagram of positions where power terminals of an electrical device are disposed according to an embodiment of this application. FIG. 2 is a schematic diagram of electrical connections between power terminals of an electrical device and power circuits of the electrical device according to an embodiment of this application.

As shown in FIG. 1 and FIG. 2, in an embodiment of this application, the electrical device may include a substrate 600. Two power terminals 100 are disposed at an interval along a first direction on the substrate 600, and each power terminal 100 is electrically connected to one power circuit 200, where the first direction is perpendicular to an insertion direction of the substrate 600.

It can be understood that, the electrical device may further include a housing (not shown), and the substrate 600 may pass through the housing, so that the two power terminals 100 are located outside the housing.

It can be understood that, the power circuits 200 electrically connected to the two power terminals 100 may form a power loop together with another circuit.

It can be understood that, the substrate 600 may be configured to connect, in a plugging manner, to an output-end connector (not shown) of a piece of power sourcing equipment, and the two power terminals 100 on the substrate 600 are separately configured to electrically contact two corresponding output terminals (not shown) of the output-end connector, so that the electrical device is electrically connected to the power sourcing equipment.

In a conventional technology, the two power terminals may be two connection terminals disposed in parallel on an edge connector, and the two power terminals are both integral structures extending along the insertion direction of the substrate. In the conventional technology, in a scenario in which hot swap is performed between an electrical device (for example, a power module) having high power and a high power density and a piece of power sourcing equipment (for example, a power supply board connected to a power grid) having a relatively high output voltage, transient impulse currents are relatively large when two power terminals of the electrical device are connected. As a result, phenomena such as sparking and ablation may easily occur at the two power terminals, bringing relatively poor user experience. In addition, the phenomena such as sparking and ablation at the two power terminals may easily affect contact impedance between the power terminal and the corresponding output terminal, thereby easily affecting electrical connections between the electrical device and the power sourcing equipment. In addition, when the two power terminals are connected, the transient impulse currents are relatively large and may easily damage components on a power loop where two power circuits are located.

Therefore, as shown in FIG. 1 and FIG. 2, in an embodiment of this application, a first capacitor 310 is disposed between the two power circuits 200 of the electrical device, one end of the first capacitor 310 is electrically connected to one of the power circuits 200, and another end of the first capacitor 310 is electrically connected to the other power circuit 200. At least one of the power terminals 100 includes a first conductive section 110, a first resistor 120, and a second conductive section 130. In the same power terminal 100, the first conductive section 110, the first resistor 120, and the second conductive section 130 are connected in series, the first conductive section 110 is electrically connected by using the first resistor 120 and the second conductive section 130 to the power circuit 200, and both the first conductive section 110 and the second conductive section 130 are located on a surface on a same side of the substrate 600. In the insertion direction of the substrate 600, the first conductive section 110 is disposed at an interval in front of the second conductive section 130, so that the first conductive section 110 is disconnected from the second conductive section 130 in the insertion direction of the substrate 600.

In this way, when hot swap is performed between the electrical device having high power and a high power density and the power sourcing equipment, the first conductive section 110 of the at least one of the power terminals 100 may first be separately and electrically in contact with an output terminal corresponding to the power sourcing equipment, so that the two power terminals 100 are connected to the power sourcing equipment. In this case, the first capacitor 310 is charged by a current that has undergone current limiting of the first resistor 120. Because of the current limiting effect of the first resistor 120, a current at the first conductive section 110 is relatively small, so that impulse currents are relatively small when the two power terminals 100 are connected to the power sourcing equipment. The first capacitor 310 is charged by using the first conductive section 110 and the first resistor 120, to enable a voltage between two ends of the first capacitor 310 to rise. Then a voltage between the two power terminals 100 is enabled to rise. When the substrate 600 continues to be inserted till the second conductive section 130 is electrically in contact with a corresponding output terminal to implement power input, potential differences between the two power terminals 100 and the two corresponding output terminals may be relatively small, or even equal potentials may be formed between the two power terminals 100 and the two corresponding output terminals. In this case, currents flowing into the corresponding power terminals 100 through the output terminals are relatively small or even may be zero, and at a moment when the second conductive section 130 is electrically in contact with the corresponding output terminal, impulse currents at the two power terminals 100 are also relatively small. In this way, a risk of phenomena such as sparking and ablation at the two power terminals 100 can be reduced, thereby helping improve user experience. In addition, this helps improve stability of contact impedance between the power terminal 100 and the corresponding output terminal, and helps improve stability of electrical connections between the electrical device and the power sourcing equipment. In addition, the relatively small impulse currents also help protect components on a power loop where the two power circuits 200 are located.

It can be understood that, when the substrate 600 of the electrical device is just connected to the output-end connector of the power sourcing equipment, for the power terminal 100 including the first conductive section 110, the first resistor 120, and the second conductive section 130, a corresponding output terminal of the output-end connector is first electrically in contact with the first conductive section 110, so that a current can flow through the first conductive section 110, the first resistor 120, and the second conductive section 130 to the first capacitor 310, so as to charge the first capacitor 310. The substrate 600 continues to be inserted till the second conductive section 130 is electrically in contact with the corresponding output terminal to implement power input, and this takes a time period. The charging in this time period enables the voltage between the two ends of the first capacitor 310 to rise, so that the voltage between the two power terminals 100 rises, and a potential difference between the power terminal 100 and the corresponding output terminal decreases.

It can be understood that, to fully charge the first capacitor 310 so that the voltage between the two power terminals 100 is relatively high, a time constant of the first capacitor 310 may be less than a charging time (that is, a time for the first conductive section 110 to be separately and electrically in contact with the output terminal corresponding to the output-end connector) for charging the first capacitor 310 by using the first conductive section 110 alone. In other words, a product of multiplying the first capacitor 310 and the first resistor 120 may be less than a value that is obtained by dividing a length of the first conductive section 110 in the insertion direction of the substrate 600 by a fastest insertion speed of the substrate 600. A capacity of the first capacitor 310 may be at a microfarad level. In this way, the time constant of the first capacitor 310 is very small, and the product of multiplying the first capacitor 310 and the first resistor 120 may be, very easily, far less than the value that is obtained by dividing the length of the first conductive section 110 in the insertion direction of the substrate 600 by the fastest insertion speed of the substrate 600. It can be understood that, after the substrate 600 is connected, in a plugging manner, to the corresponding output-end connector, for the power terminal 100 including the first conductive section 110, the first resistor 120, and the second conductive section 130, the first conductive section 110 and the second conductive section 130 each may be electrically in contact with the corresponding output terminal of the output-end connector. In other words, in the insertion direction of the substrate 600, a spacing between the first conductive section 110 and the second conductive section 130 in the same power terminal 100 may be less than a length of an electrical contact part of the corresponding output terminal in the insertion direction of the substrate 600.

In this way, the following risk can be reduced: When the electrical contact part of the output terminal moves to a position between the first conductive section 110 and the second conductive section 130 during insertion of the substrate 600, the output terminal is disconnected from both the first conductive section 110 and the second conductive section 120, causing a decrease in the voltage between the two power terminals 100. Therefore, a transient impulse current generated when the electrical contact part of the output terminal is connected to the second conductive section 130 may be further reduced, thereby further reducing a risk of phenomena such as sparking and ablation at the two power terminals 100.

It can be understood that, to disconnect the first conductive section 110 from the second conductive section 130 in the same power terminal 100 in the insertion direction of the substrate 600 so as to reduce a risk of a short circuit between the first conductive section 110 and the second conductive section 130 of the same power terminal 100 when the output terminal is electrically in contact with the first conductive section 110 alone, the spacing between the first conductive section 110 and the second conductive section 130 in the same power terminal 100 is greater than or equal to a safe spacing required by a maximum working voltage of the power terminal 100. It needs to be noted that, when a spacing between two conductors is greater than or equal to a safe spacing required by a voltage between the two conductors, a phenomenon of a short circuit does not occur between the two conductors, and insulation between the two conductors can be maintained. For a relationship between the voltage and the safety spacing, specifically refer to a related safety standard, for example, EN60950.

It can be understood that, one of the two power terminals 100 may include the first conductive section 110, the first resistor 120, and the second conductive section 130; and the other power terminal 100 is an integral structure extending along the insertion direction of the substrate 600.

Alternatively, the two power terminals 100 may both include the first conductive section 110, the first resistor 120, and the second conductive section 130.

It can be understood that, the electrical device may be an electrical device with alternating-current input. In this case, the substrate 600 may be configured to connect, in a plugging manner, to an alternating-current output-end connector of the power sourcing equipment. One of the power terminals 100 on the substrate 600 may be a live-wire terminal, the live-wire terminal may be configured to electrically contact a live-wire output terminal of the alternating-current output-end connector, and the power circuit 200 electrically connected to the live-wire terminal is a live-wire circuit. The other power terminal 100 on the substrate 600 may be a neutral-wire terminal, the neutral-wire terminal may be configured to electrically contact a neutral-wire output terminal of the alternating-current output-end connector, and the power circuit 200 electrically connected to the neutral-wire terminal is a neutral-wire circuit.

Alternatively, the electrical device may be an electrical device with direct-current input. In this case, the substrate 600 may be configured to connect, in a plugging manner, to a direct-current output-end connector of the power sourcing equipment. One of the power terminals 100 on the substrate 600 may be a positive terminal, the positive terminal may be configured to electrically contact a positive output terminal of the direct-current output-end connector, and the power circuit 200 electrically connected to the positive terminal is a positive circuit. The other power terminal 100 on the substrate 600 may be a negative terminal, the negative terminal may be configured to electrically contact a negative output terminal of the direct-current output-end connector, and the power circuit 200 electrically connected to the negative terminal is a negative circuit.

It can be understood that, the two power terminals 100 may be disposed on a same side of the substrate 600. Alternatively, the two power terminals 100 may be disposed on different sides of the substrate 600. For example, the two power terminals 100 may be separately disposed on two opposite sides of the substrate 600.

As shown in FIG. 1, in an embodiment of this application, the two power terminals 100 may be disposed on a same side of the substrate 600 in a thickness dimension of the substrate 600.

In this way, a thickness of the substrate 600 may be relatively small, and it may be relatively convenient to perform electrical connections between the first capacitor 310 and the two power circuits 200.

In an embodiment of this application, both the first conductive section 110 and the second conductive section 130 may be strip-shaped conductive sheets extending along the insertion direction of the substrate 600.

In this way, in a process in which the substrate 600 is connected, in a plugging manner, to the output-end connector of the power sourcing equipment, the first conductive section 110 and the second conductive section 130 can be stably and electrically in contact with the output terminals corresponding to the output-end connector.

It can be understood that, in the same power terminal 100, the length of the first conductive section 110 along the insertion direction of the substrate 600 may be greater than, equal to, or less than a length of the second conductive section 130 along the insertion direction of the substrate 600.

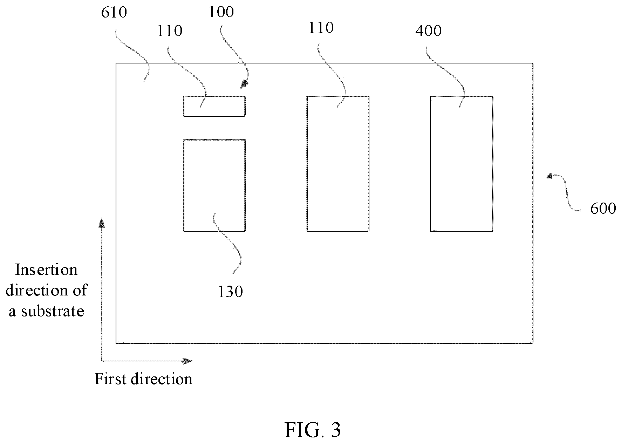

FIG. 3 is another schematic diagram of positions where power terminals of an electrical device are disposed according to an embodiment of this application.

As shown in FIG. 3, in this embodiment of this application, in the same power terminal 100, the length of the first conductive section 110 along the insertion direction of the substrate 600 is less than the length of the second conductive section 130 along the insertion direction of the substrate 600.

In this way, because of current limiting of the first resistor 120, a current flowing through the first conductive section 110 is relatively small, a required through-current area of the first conductive section 110 is relatively small, and the length of the first conductive section 110 is relatively small, so that the first conductive section 110 occupies relatively small space in the insertion direction of the substrate 600, thereby helping improve space utilization of the substrate 600 and also helping increase the length of the second conductive section 130 in the insertion direction of the substrate 600 in the same space. After the length of the second conductive section 130 increases, a through-current area of the second conductive section 130 may be relatively large, so that a relatively large current is conveyed to the power circuit 200 after the plugged connection is completed, thereby implementing input with relatively high power.

As shown in FIG. 1, in an embodiment in which a ground terminal 400 is disposed on the substrate, a power terminal 100 adjacent to the ground terminal 400 in the first direction may be the power terminal 100 including the first conductive section 110, the first resistor 120, and the second conductive section 130.

Alternatively, as shown in FIG. 3, in an embodiment in which a ground terminal 400 is disposed on the substrate, a power terminal 100 adjacent to the ground terminal 400 in the first direction may be the power terminal 100 of the integral structure extending along the insertion direction of the substrate 600.

As shown in FIG. 2 and FIG. 3, in an embodiment of this application, the electrical device may be an electrical device with alternating-current input. The power circuit 200 electrically connected to one of the power terminals 100 of the electrical device is a live-wire circuit, and the power circuit 200 electrically connected to the other power terminal 100 of the electrical device is a neutral-wire circuit. The ground terminal 400 is further disposed on the substrate 600, the ground terminal 400 is disposed at intervals from the power terminals 100 along the first direction, and the ground terminal 400 is electrically connected to a grounding circuit 500.

In this way, when hot swap is performed in a high-voltage alternating-current scenario, transient impulse currents may be relatively small when the electrical device with alternating-current input is connected, and a risk of phenomena such as sparking and ablation at the two power terminals 100 with alternating-current input may be reduced, thereby helping improve stability of electrical connections between the electrical device with alternating-current input and the power sourcing equipment and helping protect components on a power loop with alternating-current input. In addition, the disposed ground terminal 400 and the grounding circuit 500 also help protect the electrical device and the components on the power loop.

In an embodiment of this application, the power circuit 200 includes a first circuit 220, an inductor 210, and a second circuit 230 that are connected in series. One end of the inductor 210 is electrically connected to the power terminal 100 by using the first circuit 220, and one end of the first capacitor 310 is electrically connected to the first circuit 220.

In this way, the inductor 210 may play a wave filtering function, and the first circuit 220 is disposed between the inductor 210 and the power terminal 100, so as to help charge the first capacitor 310 when the first conductive section 110 is electrically in contact with the output terminal corresponding to the power sourcing equipment.

In an embodiment of this application, the first capacitor 310 is an X capacitor.

In this way, the X capacitor in the electrical device may be used to play a function of reducing the transient impulse currents when the electrical device is connected to the power sourcing equipment during the hot swap, and a quantity of required components is relatively small.

It can be understood that, the X capacitor may be configured to suppress electromagnetic interference.

In an embodiment of this application, a second capacitor 320 is further disposed between the second circuits 230 of the two power circuits 200, the second capacitor 320 is an X capacitor, one end of the second capacitor 320 is electrically connected to the second circuit 230 of one of the power circuits 200, and another end of the second capacitor 320 is electrically connected to the second circuit 230 of the other power circuit 200.

In this way, the second capacitor 320 may further play a function of reducing the transient impulse current when the first conductive section 110 is electrically in contact with the output terminal corresponding to the power sourcing equipment during the connection of the electrical device. In addition, the power circuit 200 also has a relatively good wave filtering effect.

In an embodiment of this application, the power circuit 200 is further electrically connected to a third capacitor 340, the third capacitor 340 is a Y capacitor, one end of the third capacitor 340 is electrically connected to the power circuit 200, and another end of the third capacitor 340 is electrically connected to the grounding circuit 500; a second resistor 330 is further disposed between the second circuits 230 of the two power circuits 200, one end of the second resistor 330 is electrically connected to the second circuit 230 of one of the power circuits 200, and the other end of the second resistor 330 is electrically connected to the second circuit 230 of the other power circuit 200; and in the same power circuit 200, a position of an electrical connection between the second resistor 330 and the second circuit 230 is located between the following positions: a position of an electrical connection between the third capacitor 340 and the second circuit 230, and a position of an electrical connection between the second capacitor 320 and the second circuit 230. In this way, a risk of current leakage at an output end of the power circuit 200 is relatively low, and the electrical device has relatively high safety.

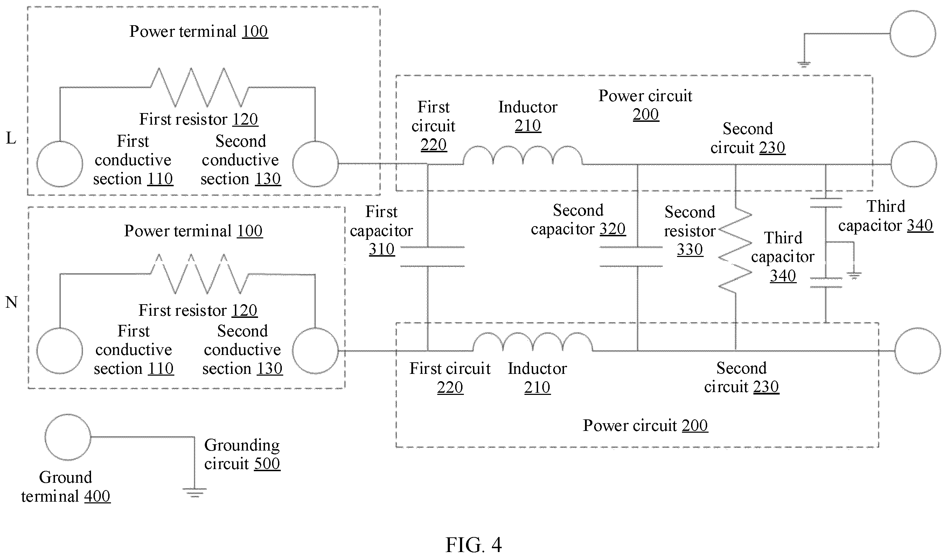

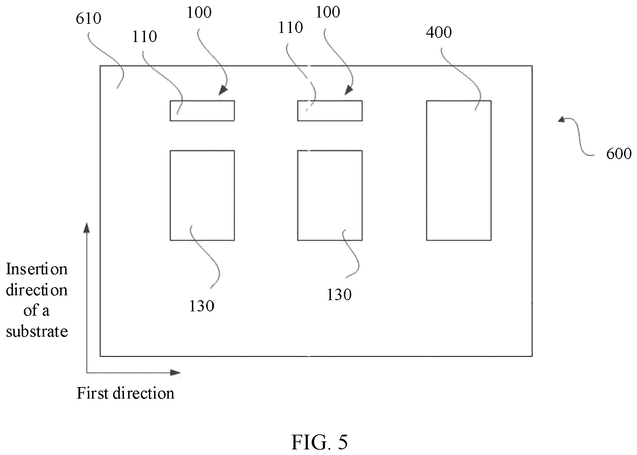

FIG. 4 is another schematic diagram of electrical connections between power terminals of an electrical device and power circuits of the electrical device according to an embodiment of this application. FIG. 5 is still another schematic diagram of positions where power terminals of an electrical device are disposed according to an embodiment of this application.

As shown in FIG. 4 and FIG. 5, with reference to FIG. 2 and FIG. 3 together, in an embodiment where the electrical device is an electrical device with alternating-current input, the power terminal 100 electrically connected to the live-wire circuit may be the power terminal 100 including the first conductive section 110, the first resistor 120, and the second conductive section 130. In this case, the power terminal 100 electrically connected to the neutral-wire circuit may be the power terminal 100 of the integral structure extending along the insertion direction of the substrate 600; or the power terminal 100 electrically connected to the neutral-wire circuit may be the power terminal 100 including the first conductive section 110, the first resistor 120, and the second conductive section 130.

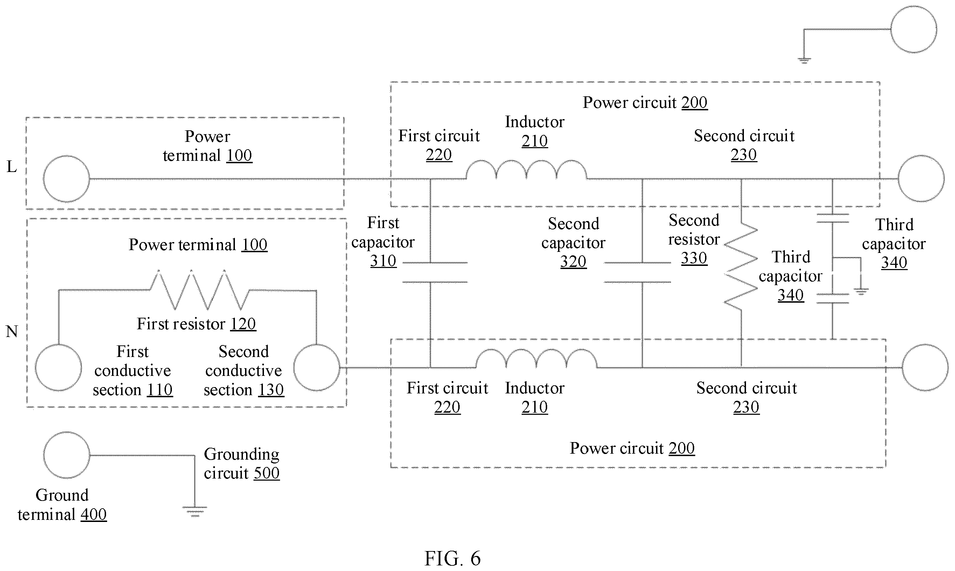

FIG. 6 is still another schematic diagram of electrical connections between power terminals of an electrical device and power circuits of the electrical device according to an embodiment of this application.

As shown in FIG. 6, with reference to FIG. 3 to FIG. 5 together, in an embodiment in which the electrical device is an electrical device with alternating-current input, the power terminal 100 electrically connected to the neutral-wire circuit may be alternatively the power terminal 100 including the first conductive section 110, the first resistor 120, and the second conductive section 130. In this case, the power terminal 100 electrically connected to the live-wire circuit may be the power terminal 100 of the integral structure extending along the insertion direction of the substrate 600; or the power terminal 100 electrically connected to the live-wire circuit may be the power terminal 100 including the first conductive section 110, the first resistor 120, and the second conductive section 130.

Certainly, the electrical device may be alternatively an electrical device with direct-current input, where the power circuit 200 electrically connected to one of the power terminals 100 of the electrical device is a positive circuit, and the power circuit 200 electrically connected to the other power terminal 100 of the electrical device is a negative circuit.

In an embodiment of this application, in addition to the power terminal 100 and the ground terminal 400, another terminal (not shown) such as a signal terminal may be further disposed on the substrate 600.

As shown in FIG. 4 and FIG. 5, in an embodiment of this application, the two power terminals 100 each include the first conductive section 110, the first resistor 120, and the second conductive section 130. In the first direction, the first conductive sections 110 of the two power terminals 100 are disposed as being opposite to each other in the front of the insertion direction of the substrate 600.

In this way, when hot swap is performed between the electrical device having high power and a high power density and the power sourcing equipment, first, the first capacitor 310 is charged by using the first conductive section 110. This is relatively stable, and can reduce the following risk: If the substrate 600 is slant during the insertion for connecting the electrical device to the power sourcing equipment, the second conductive section 130 is in contact with the corresponding output terminal earlier than the first conductive section 110, or the second conductive section 130 and the first conductive section 110 are electrically in contact with the corresponding output terminals at the same time, causing excessively large impulse currents.

In an embodiment of this application, in the insertion direction of the substrate 600, the length of the first conductive section 110 is the same for the two power terminals 100, and the spacing between the first conductive section 110 and the second conductive section 130 is the same for the two power terminals 100.

In this way, the two power terminals 100 on the substrate 600 may be arranged more compactly, and space utilization of the substrate 600 is relatively high.

In an embodiment of this application, in the same power terminal 100, a projection of the first conductive section 110 along the insertion direction of the substrate 600 overlaps at least partially with a projection of the second conductive section 130 along the insertion direction of the substrate 600.

In this way, when the substrate 600 is inserted, the first conductive section 110 and the second conductive section 130 in the same power terminal 100 are sequentially and electrically in contact with the corresponding output terminals that extend in a straight line along the insertion direction of the substrate 600, thereby helping reduce a size of the output-end connector that is configured to connect, in a plugging manner, to the substrate 600.

It can be understood that, in the same power terminal 100, the projection of the first conductive section 110 along the insertion direction of the substrate 600 may partially fall within the projection of the second conductive section 130 along the insertion direction of the substrate 600, and partially fall outside the projection of the second conductive section 130 along the insertion direction of the substrate 600.

In an embodiment of this application, in the same power terminal 100, the projection of the first conductive section 110 along the insertion direction of the substrate 600 falls within the projection of the second conductive section 130 along the insertion direction of the substrate 600.

In this way, the power terminal 100 including the first conductive section 110, the first resistor 120, and the second conductive section 130 has little impact on another adjacent terminal on the substrate 600.

In an embodiment of this application, the substrate 600 includes a printed circuit board 610, and the two power terminals 100 are disposed at the interval along the first direction on the printed circuit board 610; and both the first conductive section 110 and the second conductive section 130 are located on a surface on a same side of the printed circuit board 610, and the power circuit 200 is located at least partially on the printed circuit board 610.

In this way, it is relatively easy to dispose the power terminal 100 and the power circuit 200.

It can be understood that, the two power terminals 100 may be disposed on a same side of the printed circuit board 610 in a thickness dimension of the printed circuit board 610.

It can be understood that, the printed circuit board 610 may be a mainboard of the electrical device, or may be a transfer board of the electrical device.

It can be understood that, the power circuit 200 may be totally located on the printed circuit board 610, or may be only partially disposed on the printed circuit board 610.

It can be understood that, both the first resistor 120 and the first capacitor 310 may be disposed on the printed circuit board 610; or either of the first resistor 120 and the first capacitor 310 may be disposed on the printed circuit board 610, and the other is not disposed on the printed circuit board 610; or neither the first resistor 120 nor the first capacitor 310 may be disposed on the printed circuit board 610.

It can be understood that, in the power terminal 100 that includes the first conductive section 110 and the second conductive section 130, the first conductive section 110 and the second conductive section 130 may be formed by interrupting a connection terminal on the printed circuit board 610.

It can be understood that, when one of the power terminals 100 is the integral power terminal 100 extending along the insertion direction of the substrate 600, the integral power terminal 100 extending along the insertion direction of the substrate 600 may be a connection terminal.

In an embodiment of this application, the first resistor 120 may be disposed on the printed circuit board 610.

In this way, it is relatively convenient to dispose the first resistor 120, and electrically connect the first resistor 120 to the first conductive section 110 and the second conductive section 130.

In an embodiment of this application, the first capacitor 310 may be disposed on the printed circuit board 610.

In this way, it is relatively convenient to dispose the first capacitor 310, and electrically connect the first capacitor 310 to the two power circuits 200.

Certainly, the substrate 600 may alternatively include an insulation mechanical part (not shown), both the power terminal 100 and the ground terminal 400 may be conductive pins, the power terminal 100 and the ground terminal 400 may be disposed on the insulation mechanical part, and the power terminal 100 and the ground terminal 400 may form an integral structure with the insulation mechanical part by using injection molding.

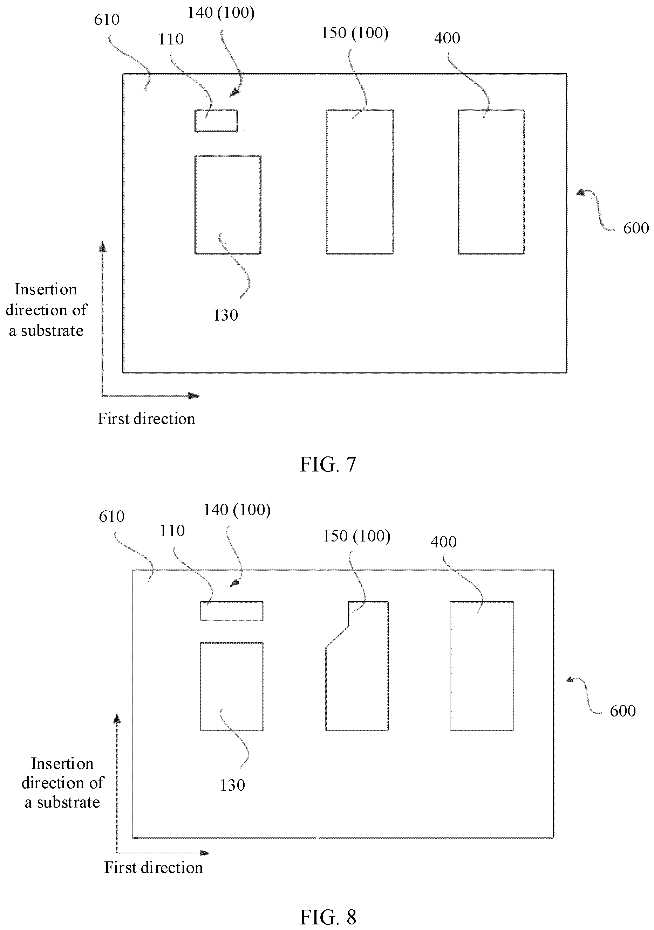

FIG. 7 is yet another schematic diagram of positions where power terminals of an electrical device are disposed according to an embodiment of this application.

As shown in FIG. 7, in this embodiment of this application, one of the two power terminals 100 is a first power terminal 140, and the other is a second power terminal 150. The first power terminal 140 includes the first conductive section 110, the first resistor 120, and the second conductive section 130. In the first direction, a spacing between the first conductive section 110 of the first power terminal 140 and the second power terminal 150 is greater than a spacing between the second conductive section 130 of the first power terminal 140 and the second power terminal 150.

In this way, the spacing between the first conductive section 110 of the first power terminal 140 and the second power terminal 150 is relatively large, so that a risk of phenomena of sparking and arcing between the first power terminal 140 and the second power terminal 150 can be reduced during the hot swap between the electrical device and the power sourcing equipment, and a risk of phenomena of breakdown and a short circuit between the first power terminal 140 and the second power terminal 150 is relatively low. In addition, the spacing between the second conductive section 130 of the first power terminal 140 and the second power terminal 150 is relatively small. This helps improve space utilization of the substrate 600, and helps increase a through-current area of the second conductive section 130 of the first power terminal 140, so that the second conductive section 130 of the first power terminal 140 has a relatively strong through-current capability.

It can be understood that, the second power terminal 150 may be the power terminal 100 including the first conductive section 110, the first resistor 120, and the second conductive section 130, or may be the integral power terminal 100 extending along the insertion direction of the substrate 600.

It can be understood that, the spacing between the first conductive section 110 of the first power terminal 140 and the second power terminal 150 in the first direction may be greater than an arc-extinguishing distance. It needs to be noted that, the arc-extinguishing distance is a distance that needs to be satisfied so that there is no arc breakdown between the first conductive section 110 of the first power terminal 140 and the second power terminal 150, or an arc can be automatically extinguished when an alternating-current voltage crosses zero after arc breakdown between the first conductive section 110 of the first power terminal 140 and the second power terminal 150. A value of the distance depends on a working voltage and a working current between the first power terminal 140 and the second power terminal 150 when the first power terminal 140 and the second power terminal 150 are connected to or disconnected from corresponding output terminals. The arc-extinguishing distance may have different values in different application scenarios, provided that arc extinguishing can be implemented.

In this embodiment of this application, in the first direction, a width of the first conductive section 110 of the first power terminal 140 is less than a width of the second conductive section 130 of the first power terminal 140.

In this way, the spacing between the first conductive section 110 of the first power terminal 140 and the second power terminal 150 can be increased.

It can be understood that, in this case, in the first direction, a width of a part that is of the second power terminal 150 and that is opposite to the first conductive section 110 of the first power terminal 140 may be less than or equal to a width of a part that is of the second power terminal 150 and that is opposite to the second conductive section 130 of the first power terminal 140.

It can be understood that, a side that is of the first conductive section 110 of the first power terminal 140 and that is away from the second power terminal 150 in the first direction may be flush to a side that is of the second conductive section 130 of the first power terminal 140 and that is away from the second power terminal 150 in the first direction. FIG. 8 is still yet another schematic diagram of positions where power terminals of an electrical device are disposed according to an embodiment of this application.

As shown in FIG. 8, in this embodiment of this application, in the first direction, a width of a part that is of the second power terminal 150 and that is opposite to the first conductive section 110 of the first power terminal 140 is less than a width of a part that is of the second power terminal 150 and that is opposite to the second conductive section 130 of the first power terminal 140.

In this way, the spacing between the first conductive section 110 of the first power terminal 140 and the second power terminal 150 can be increased.

It can be understood that, in this case, in the first direction, a width of the first conductive section 110 of the first power terminal 140 may be less than or equal to a width of the second conductive section 130 of the first power terminal 140.

For example, when the second power terminal 150 is the integral power terminal 100 extending along the insertion direction of the substrate 600, the second power terminal 150 may have a notch (not shown) that runs through a side facing the first power terminal 140 in the front of the insertion direction of the substrate 600; and in the first direction, the first conductive section 110 of the first power terminal 140 is opposite to the notch. In this way, the width of the part that is of the second power terminal 150 and that is opposite to the first conductive section 110 of the first power terminal 140 can be less than the width of the part that is of the second power terminal 150 and that is opposite to the second conductive section 130 of the first power terminal 140.

It can be understood that, the notch may include two side edges, and the two side edges may be perpendicular to each other, or the two side edges may intersect at an obtuse angle with each other.

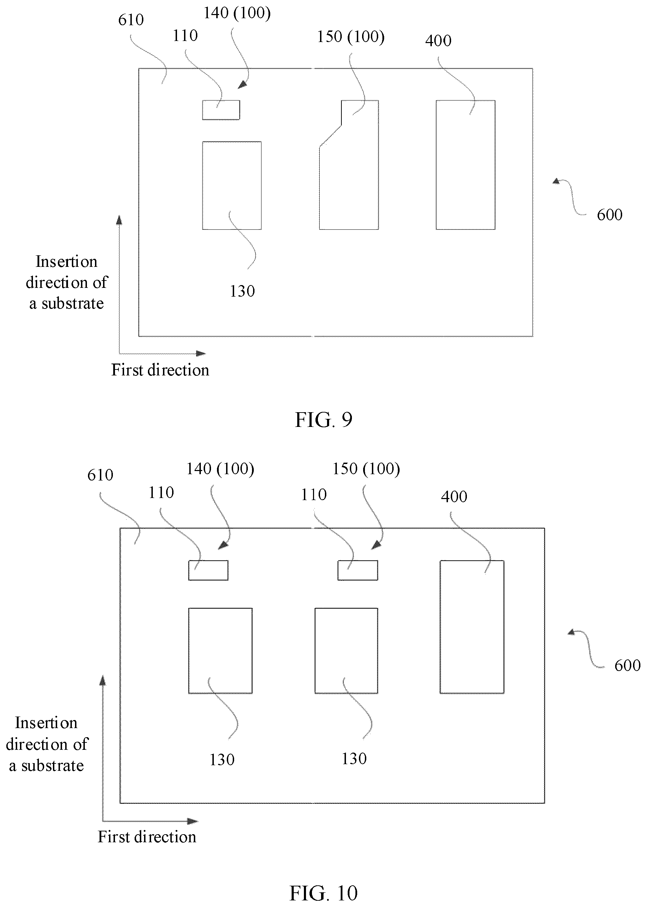

FIG. 9 is a further schematic diagram of positions where power terminals of an electrical device are disposed according to an embodiment of this application. FIG. 10 is a still further schematic diagram of positions where power terminals of an electrical device are disposed according to an embodiment of this application.

As shown in FIG. 9 and FIG. 10, in the first direction, the width of the first conductive section 110 of the first power terminal 140 is less than the width of the second conductive section 130 of the first power terminal 140, and the width of the part that is of the second power terminal 150 and that is opposite to the first conductive section 110 of the first power terminal 140 is less than the width of the part that is of the second power terminal 150 and that is opposite to the second conductive section 130 of the first power terminal 140.

In this way, the spacing between the first conductive section 110 of the first power terminal 140 and the second power terminal 150 is relatively large, and safety is relatively high.

It can be understood that, as shown in FIG. 10, when the second power terminal 150 is the power terminal 100 including the first conductive section 110, the first resistor 120, and the second conductive section 130, a width of the first conductive section 110 of the second power terminal 150 may be less than a width of the second conductive section 130 of the second power terminal 150.

In descriptions of embodiments of this application, unless otherwise clearly specified and limited, the terms "installation", "connection to", and "connection" should be understood in a broad sense. For example, the connection may be a fixed connection, may be an indirect connection by using an intermediate medium, or may be an internal connection between two elements or an interaction relationship between two elements. For persons of ordinary skill in the art, specific meanings of the foregoing terms in embodiments of this application can be understood based on a specific situation.

In the specification, claims, and accompanying drawings in embodiments of this application, the terms "first", "second", "third", "fourth", and the like (if available) are intended to distinguish between similar objects but do not necessarily indicate a specific order or sequence.

Finally, it should be noted that the foregoing embodiments are merely intended for describing the technical solutions of embodiments of this application rather than limiting this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. An electrical device, comprising a substrate (600), wherein
two power terminals (100) are disposed at an interval along a first direction on the substrate (600), each power terminal (100) is electrically connected to a power circuit (200);
at least one of the power terminals (100) comprises a first conductive section (110), a resistor, and a second conductive section (130); and
in the same power terminal (100), the first conductive section (110), the resistor, and the second conductive section (130) are connected in series, the first conductive section (110) is electrically connected, by using the resistor and the second conductive section (130), to the power circuit (200), both the first conductive section (110) and the second conductive section (130) are located on a surface on a same side of the substrate (600), and in an insertion direction of the substrate (600), the first conductive section (110) is disposed at an interval in front of the second conductive section (130), so that the first conductive section (110) is disconnected from the second conductive section (130) in the insertion direction of the substrate (600); wherein
the first direction is perpendicular to the insertion direction of the substrate (600), **characterized in that**
capacitors are disposed between the two power circuits (200), one end of the capacitor is electrically connected to one power circuit (200), and another end of the capacitor is electrically connected to the other power circuit (200); one of the two power terminals (100) is a first power terminal (140), the other is a second power terminal (150), and the first power terminal (140) comprises the first conductive section (110), the resistor, and the second conductive section (130); and wherein a spacing between the first conductive section (110) of the first power terminal (140) and the second power terminal (150) is greater than a spacing between the second conductive section (130) of the first power terminal (140) and the second power terminal (150) in the first direction.

2. The electrical device according to claim 1, wherein in the same power terminal (100), a projection of the first conductive section (110) along the insertion direction of the substrate (600) at least partially overlaps with a projection of the second conductive section (130) along the insertion direction of the substrate (600).

3. The electrical device according to claim 2, wherein in the same power terminal (100), the projection of the first conductive section (110) along the insertion direction of the substrate (600) falls within the projection of the second conductive section (130) along the insertion direction of the substrate (600).

4. The electrical device according to any one of claims 1 to 3, wherein the substrate (600) comprises a printed circuit board (610), and the two power terminals (100) are disposed at the interval along the first direction on the printed circuit board (610); and
both the first conductive section (110) and the second conductive section (130) are located on a surface on a same side of the printed circuit board (610), and the power circuit (200) is located at least partially on the printed circuit board (610).

5. The electrical device according to claim 4, wherein the resistor is disposed on the printed circuit board (610).

6. The electrical device according to any one of claims 1 to 3, wherein both the first conductive section (110) and the second conductive section (130) are strip-shaped conductive sheets extending along the insertion direction of the substrate (600).

7. The electrical device according to claim 1, wherein in the first direction, a width of the first conductive section (110) of the first power terminal (140) is less than a width of the second conductive section (130) of the first power terminal (140); and/or
in the first direction, a width of a part that is of the second power terminal (150) and that is opposite to the first conductive section (110) of the first power terminal (140) is less than a width of a part that is of the second power terminal (150) and that is opposite to the second conductive section (130) of the first power terminal (140).

8. The electrical device according to any one of claims 1 to 3, wherein in the same power terminal (100), a length of the first conductive section (110) along the insertion direction of the substrate (600) is less than a length of the second conductive section (130) along the insertion direction of the substrate (600).

9. The electrical device according to any one of claims 1 to 3, wherein each of the two power terminals (100) comprises the first conductive section (110), the resistor, and the second conductive section (130); and
in the first direction, the first conductive sections (110) of the two power terminals (100) are disposed as being opposite to each other in the front of the insertion direction of the substrate (600).

10. The electrical device according to any one of claims 1 to 3, wherein the power circuit (200) is electrically connected to one of the power terminals (100), and the power circuit (200) is electrically connected to the other power terminal (100) ; and
a ground terminal (400) is further disposed on the substrate (600), the ground terminal (400) is disposed at intervals from the power terminals (100) along the first direction, and the ground terminal (400) is electrically connected to a grounding circuit (500).

## Patentansprüche

1. Elektrische Vorrichtung, umfassend ein Substrat (600), wobei zwei Leistungsendgeräte (100) in einem Intervall entlang einer ersten Richtung auf dem Substrat (600) angeordnet sind, wobei jedes Leistungsendgerät (100) elektrisch mit einer Leistungsschaltung (200) verbunden ist;
mindestens eines der Leistungsendgeräte (100) einen ersten leitenden Abschnitt (110), einen Widerstand und einen zweiten leitenden Abschnitt (130) umfasst; und
in demselben Leistungsendgerät (100) der erste leitende Abschnitt (110), der Widerstand und der zweite leitende Abschnitt (130) in Reihe geschaltet sind, der erste leitende Abschnitt (110) mithilfe des Widerstands und des zweiten leitenden Abschnitts (130) elektrisch mit der Leistungsschaltung (200) verbunden ist, sowohl der erste leitende Abschnitt (110) als auch der zweite leitende Abschnitt (130) sich auf einer Oberfläche auf einer selben Seite des Substrats (600) befinden und in einer Einschubrichtung des Substrats (600) der erste leitende Abschnitt (110) in einem Intervall vor dem zweiten leitenden Abschnitt (130) angeordnet ist, sodass der erste leitende Abschnitt (110) in der Einschubrichtung des Substrats (600) von dem zweiten leitenden Abschnitt (130) getrennt ist; wobei
die erste Richtung senkrecht zu der Einschubrichtung des Substrats (600) ist, **dadurch gekennzeichnet, dass**
Kondensatoren zwischen den zwei Leistungsschaltungen (200) angeordnet sind, ein Ende des Kondensators elektrisch mit einer Leistungsschaltung (200) verbunden ist und ein anderes Ende des Kondensators elektrisch mit der anderen Leistungsschaltung (200) verbunden ist; eines der zwei Leistungsendgeräte (100) ein erstes Leistungsendgerät (140) ist, das andere ein zweites Leistungsendgerät (150) ist und das erste Leistungsendgerät (140) den ersten leitenden Abschnitt (110), den Widerstand und den zweiten leitenden Abschnitt (130) umfasst; und wobei ein Abstand zwischen dem ersten leitenden Abschnitt (110) des ersten Leistungsendgeräts (140) und dem zweiten Leistungsendgerät (150) in der ersten Richtung größer ist als ein Abstand zwischen dem zweiten leitenden Abschnitt (130) des ersten Leistungsendgeräts (140) und dem zweiten Leistungsendgerät (150).

2. Elektrische Vorrichtung nach Anspruch 1, wobei sich in demselben Leistungsendgerät (100) eine Projektion des ersten leitenden Abschnitts (110) entlang der Einschubrichtung des Substrats (600) mindestens teilweise mit einer Projektion des zweiten leitenden Abschnitts (130) entlang der Einschubrichtung des Substrats (600) überlappt.

3. Elektrische Vorrichtung nach Anspruch 2, wobei in demselben Leistungsendgerät (100) die Projektion des ersten leitenden Abschnitts (110) entlang der Einschubrichtung des Substrats (600) mindestens teilweise innerhalb der Projektion des zweiten leitenden Abschnitts (130) entlang der Einschubrichtung des Substrats (600) fällt.

4. Elektrische Vorrichtung nach einem der Ansprüche 1 bis 3, wobei das Substrat (600) eine Leiterplatte (610) umfasst und die zwei Leistungsendgeräte (100) in dem Intervall entlang der ersten Richtung auf der Leiterplatte (610) angeordnet sind; und
sowohl der erste leitende Abschnitt (110) als auch der zweite leitende Abschnitt (130) sich auf einer Oberfläche auf einer selben Seite der Leiterplatte (610) befinden und die Leistungsschaltung (200) sich mindestens teilweise auf der Leiterplatte (610) befindet.

5. Elektrische Vorrichtung nach Anspruch 4, wobei der Widerstand auf der Leiterplatte (610) angeordnet ist.

6. Elektrische Vorrichtung nach einem der Ansprüche 1 bis 3, wobei sowohl der erste leitende Abschnitt (110) als auch der zweite leitende Abschnitt (130) streifenförmige leitende Flachteile sind, die sich entlang der Einschubrichtung des Substrats (600) erstrecken.

7. Elektrische Vorrichtung nach Anspruch 1, wobei in der ersten Richtung eine Breite des ersten leitenden Abschnitts (110) des ersten Leistungsendgeräts (140) geringer ist als eine Breite des zweiten leitenden Abschnitts (130) des ersten Leistungsendgeräts (140); und/oder
in der ersten Richtung eine Breite eines Teils, der von dem zweiten Leistungsendgerät (150) ist und der dem ersten leitenden Abschnitt (110) des ersten Leistungsendgeräts (140) gegenüberliegt, geringer ist als eine Breite eines Teils, der von dem zweiten Leistungsendgerät (150) ist und der dem zweiten leitenden Abschnitt (130) des ersten Leistungsendgeräts (140) gegenüberliegt.

8. Elektrische Vorrichtung nach einem der Ansprüche 1 bis 3, wobei in demselben Leistungsendgerät (100) eine Länge des ersten leitenden Abschnitts (110) entlang der Einschubrichtung des Substrats (600) geringer ist als eine Länge des zweiten leitenden Abschnitts (130) entlang der Einschubrichtung des Substrats (600).

9. Elektrische Vorrichtung nach einem der Ansprüche 1 bis 3, wobei jedes der zwei Leistungsendgeräte (100) den ersten leitenden Abschnitt (110), den Widerstand und den zweiten leitenden Abschnitt (130) umfasst; und
die ersten leitenden Abschnitte (110) der zwei Leistungsendgeräte (100) in der ersten Richtung einander gegenüberliegend vor der Einsteckrichtung des Substrats (600) angeordnet sind.

10. Elektrische Vorrichtung nach einem der Ansprüche 1 bis 3, wobei die Leistungsschaltung (200) elektrisch mit einem der Leistungsendgeräte (100) verbunden ist und die Leistungsschaltung (200) elektrisch mit dem anderen Leistungsendgerät (100) verbunden ist; und
auf dem Substrat (600) ferner ein Erdungsendgerät (400) angeordnet ist, das Erdungsendgerät (400) in Intervallen von den Leistungsendgeräten (100) entlang der ersten Richtung angeordnet ist und das Erdungsendgerät (400) elektrisch mit einer Erdungsschaltung (500) verbunden ist.

## Revendications

1. Dispositif électrique, comprenant un substrat (600), dans lequel
deux bornes d'alimentation (100) sont disposées à un intervalle le long d'une première direction sur le substrat (600), chaque borne d'alimentation (100) est connectée électriquement à un circuit d'alimentation (200) ;
au moins l'une des bornes d'alimentation (100) comprend une première section conductrice (110), une résistance et une seconde section conductrice (130) ; et
dans la même borne d'alimentation (100), la première section conductrice (110), la résistance et la seconde section conductrice (130) sont connectées en série, la première section conductrice (110) est connectée électriquement, à l'aide de la résistance et de la seconde section conductrice (130), au circuit d'alimentation (200), la première (110) et la seconde section conductrice (130) sont situées sur une surface du même côté du substrat (600), et dans une direction d'insertion du substrat (600), la première section conductrice (110) est disposée à un intervalle devant la seconde section conductrice (130), de sorte que la première section conductrice (110) est déconnectée de la seconde section conductrice (130) dans la direction d'insertion du substrat (600) ; dans lequel
la première direction est perpendiculaire à la direction d'insertion du substrat (600), **caractérisé en ce que**
des condensateurs sont disposés entre les deux circuits d'alimentation (200), une extrémité du condensateur est connectée électriquement à un circuit d'alimentation (200), et une autre extrémité du condensateur est connectée électriquement à l'autre circuit d'alimentation (200) ; l'une des deux bornes d'alimentation (100) est une première borne d'alimentation (140), l'autre est une seconde borne d'alimentation (150), et la première borne d'alimentation (140) comprend la première section conductrice (110), la résistance et la seconde section conductrice (130) ; et dans lequel un espacement entre la première section conductrice (110) de la première borne d'alimentation (140) et la seconde borne d'alimentation (150) est supérieur à un espacement entre la seconde section conductrice (130) de la première borne d'alimentation (140) et la seconde borne d'alimentation (150) dans la première direction.

2. Dispositif électrique selon la revendication 1, dans lequel dans la même borne d'alimentation (100), une projection de la première section conductrice (110) le long de la direction d'insertion du substrat (600) chevauche au moins partiellement une projection de la seconde section conductrice (130) le long de la direction d'insertion du substrat (600).

3. Dispositif électrique selon la revendication 2, dans lequel dans la même borne d'alimentation (100), la projection de la première section conductrice (110) le long de la direction d'insertion du substrat (600) retombe au niveau de la projection de la seconde section conductrice (130) le long de la direction d'insertion du substrat (600).

4. Dispositif électrique selon l'une quelconque des revendications 1 à 3, dans lequel le substrat (600) comprend une carte de circuit imprimé (610), et les deux bornes d'alimentation (100) sont disposées au niveau de l'intervalle le long de la première direction sur la carte de circuit imprimé (610) ; et
la première section conductrice (110) et la seconde section conductrice (130) sont toutes deux situées sur une surface d'un même côté de la carte de circuit imprimé (610), et le circuit d'alimentation (200) est situé au moins partiellement sur la carte de circuit imprimé (610).

5. Dispositif électrique selon la revendication 4, dans lequel la résistance est disposée sur la carte de circuit imprimé (610).

6. Dispositif électrique selon l'une quelconque des revendications 1 à 3, dans lequel la première section conductrice (110) et la seconde section conductrice (130) sont toutes deux des feuilles conductrices en forme de bande se prolongeant le long de la direction d'insertion du substrat (600).

7. Dispositif électrique selon la revendication 1, dans lequel, dans la première direction, une largeur de la première section conductrice (110) de la première borne d'alimentation (140) est inférieure à une largeur de la seconde section conductrice (130) de la première borne d'alimentation (140) ; et/ou
dans la première direction, une largeur d'une partie de la seconde borne d'alimentation (150) qui est opposée à la première section conductrice (110) de la première borne d'alimentation (140) est inférieure à une largeur d'une partie de la seconde borne d'alimentation (150) qui est opposée à la seconde section conductrice (130) de la première borne d'alimentation (140).

8. Dispositif électrique selon l'une quelconque des revendications 1 à 3, dans lequel dans la même borne d'alimentation (100), une longueur de la première section conductrice (110) le long de la direction d'insertion du substrat (600) est inférieure à une longueur de la seconde section conductrice (130) le long de la direction d'insertion du substrat (600).

9. Dispositif électrique selon l'une quelconque des revendications 1 à 3, dans lequel chacune des deux bornes d'alimentation (100) comprend la première section conductrice (110), la résistance et la seconde section conductrice (130) ; et dans la première direction, les premières sections conductrices (110) des deux bornes d'alimentation (100) sont disposées de manière à être opposées l'une à l'autre à l'avant de la direction d'insertion du substrat (600).

10. Dispositif électrique selon l'une quelconque des revendications 1 à 3, dans lequel le circuit d'alimentation (200) est connecté électriquement à l'une des bornes d'alimentation (100), et le circuit d'alimentation (200) est connecté électriquement à l'autre borne d'alimentation (100) ; et
une borne de terre (400) est également disposée sur le substrat (600), la borne de terre (400) est disposée au niveau d'intervalles des bornes d'alimentation (100) le long de la première direction, et la borne de terre (400) est connectée électriquement à un circuit de mise à la terre (500).
